# EUROPÄISCHE PATENTSCHRIFT

(11) **EP 3 423 395 B1**
(45) Veröffentlichungstag und Bekanntmachung des Hinweises auf die Patenterteilung: **20.07.2022**
(21) Anmeldenummer: 17700968.5
(22) Anmeldetag: 20.01.2017
(51) Int. Cl.: B67C 3/28, F03G 7/06, F16K 31/00, F16K 31/02

(54) **BEFÜLLUNGSEINHEIT SOWIE GETRÄNKEABFÜLLANLAGE**
FILLING UNIT AND BEVERAGE FILLING SYSTEM
UNITÉ DE REMPLISSAGE ET INSTALLATION DE REMPLISSAGE POUR BOISSONS

(30) Priorität: 01.03.2016 DE 102016103661
(43) Veröffentlichungstag der Anmeldung: 09.01.2019
(73) Patentinhaber: KHS GmbH, 44143 Dortmund (DE)
(72) Erfinder: OHREM, Jochen, 55545 Bad Kreuznach (DE); LORENZ, Jonathan, 55545 Bad Kreuznach (DE); BRUCH, Bernd, 55595 Weinsheim (DE); CLÜSSERATH, Ludwig, 55543 Bad Kreuznach (DE)
(86) Internationale Anmeldenummer: PCT/EP2017/051145
(87) Internationale Veröffentlichungsnummer: WO 2017/148614

(56) Entgegenhaltungen:
- WO-A1-2010/054775
- DE-A1-102013 214 952
- DE-U1- 29 913 326

## Beschreibung

Die vorliegende Erfindung betrifft eine Befüllungseinheit gemäß dem Oberbegriff des Anspruchs 1 für eine Getränkeabfüllanlage sowie eine Getränkeabfüllanlage.

Getränkeabfüllanlagen werden verwendet zum industriellen Abfüllen von Getränken, hierbei sowohl für sogenannte Soft-Drinks als auch alkoholische Getränke.

Für den Abfüllvorgang sind eine Vielzahl von Ventilen notwendig, die das Getränk in der gewünschten Menge in das zu befüllende Behältnis einleiten. Außerdem werden die Behälter vor dem Befüllen zunächst ggf. evakuiert, um den darin vorhandenen Sauerstoff zu verdrängen und beispielsweise anschließend mit Kohlendioxid unter ca. 2 bar geflutet. Das Öffnen und Schließen der Ventile wird mittels Aktuatoren gesteuert, die die erforderliche Bewegung mit der nötigen Kraft erzeugen. Gegenwärtig werden hierzu insbesondere elektro-pneumatische Aktuatoren verwendet.

Allerdings ist vorgesehen, die heute verwendeten elektro-pneumatischen Aktuatoren durch andere Aktuatoren zu ersetzen, da die Verwendung von elektro-pneumatischen Aktuatoren vergleichsweise teuer ist.

Aus dem Stand der Technik ist beispielsweise bereits ein elektro-magnetisches Ventil für ein Füllorgan einer Getränkeabfüllanlage aus der DE 10 2012 105 374 A1 bekannt.

Eine Füllmaschine zum Füllen von Behältern ist beispielsweise aus der DE 203 19 619 U1 bekannt. Aus der DE 10 2010 032 398 A1 ist eine Befüllungseinheit gemäß dem Oberbegriff des Anspruchs 1 bekannt.

Es ist die Aufgabe der vorliegenden Erfindung, eine Befüllungseinheit für eine Getränkeabfüllanlage sowie eine Getränkeabfüllanlage in vorteilhafter Weise weiterzubilden, insbesondere dahingehend, dass ein Aktuator einfacher aufgebaut, kostengünstiger herstellbar und mit langer Standzeit bereitgestellt werden kann.

Diese Aufgabe wird erfindungsgemäß durch eine Befüllungseinheit mit den Merkmalen des Anspruchs 1 gelöst. Danach ist vorgesehen, dass das Aktuatorelement aus einem Material besteht, das in Abhängigkeit von einem ersten Steuersignal eine erste Ausdehnung annimmt, in der das Aktuatorelement eine erste Ruheposition einnimmt, und das in Abhängigkeit von dem zweiten Steuersignal eine Ausdehnung annimmt, in der das Aktuatorelement eine zweite Anstellposition einnimmt, wobei die Stellkraft 200 bis 400 N beträgt.

Die Erfindung basiert auf dem Grundgedanken, einen Aktuator zur Steuerung wenigstens eines Fluidweges einer Befüllungseinheit für eine Getränkeabfüllanlage mit einem Aktuatorelement zu versehen, der aufgrund seiner Materialeigenschaften derart einfach angesteuert werden kann, dass aufgrund einer Formänderung des Aktuatorelements dieser wenigstens in zwei definierte Positionen, hier eine Ruheposition und eine Anstellposition, gebracht werden kann. In der Ruheposition kann beispielsweise vorgesehen sein, dass der Fluidweg gesperrt ist. Des Weiteren ist dann vorgesehen, dass in der Anstellposition der Fluidweg gesperrt wird. In diesem Zusammenhang ist insbesondere denkbar, dass die Stellkraft, die durch das Aktuatorelement in diesem Zusammenhang, hier beispielsweise in der Anstellposition, ausgeübt wird, ausreichend ist, um den Fluidweg dichtend zu verschließen. Grundsätzlich denkbar ist aber auch, dass die Ruheposition eine Position ist, in der der Fluidweg gesperrt ist und die Anstellposition eine Position, in der der Fluidweg geöffnet ist. In diesem Fall würde man von einem "Normally-Closed"-Aktuator (NORMAL GESCHLOSSEN Konfiguration) sprechen. Im vorstehend dargestellten Fall kann man von einem "Normally-Open"-Aktuator (NORMAL OFFEN Konfiguration) sprechen. Bei dem Fluidweg kann es sich insbesondere um einen Gasweg einer Befüllungseinheit handeln. Grundsätzlich denkbar ist aber auch, dass es sich um einen Fluidweg, etwa einen Fluidweg zur Leitung des abzufüllenden Getränks handelt.

Des Weiteren kann vorgesehen sein, dass die Stellkraft 350-370 N, vorzugsweise 360 N beträgt. Diese Größenordnung einer Stellkraft hat sich als besonders vorteilhaft erwiesen, um einen sicheren Verschluss der Fluidwege bei den Arbeitsdrücken, die in der Befüllungseinheit und in der Getränkeabfüllanlage vorherrschen, bereitzustellen. Darüber hinaus kann vorgesehen sein, dass das Material des Aktuatorelements ein magnetorheologisches Elastomer ist oder umfasst. Insbesondere kann vorgesehen sein, dass das magnetorheologische Elastomer durch ein extern anlegbares Magnetfeld, beispielsweise durch eine Ringspule aktiviert werden kann.

Magnetorheologische Elastomere (MRE) sind beispielsweise Komposite aus magnetisierbaren Partikeln, wie Eisen in einer Elastomermatrix wie Silikon oder Naturkautschuk. Beim Anlegen eines Magnetfelds verformt sich der MRE-Körper und führt eine aktuatorische Bewegung aus. Auch hier geht das Material beim Abschalten des Magnetfelds wieder in seine anfängliche Form zurück. Die Bewegung kann innerhalb weniger Millisekunden ausgeführt werden, sofern das Magnetfeld schnell genug aufgebaut werden kann.

Des Weiteren kann vorgesehen sein, dass das Material des Aktuatorelements eine magnetorheologische Flüssigkeit oder ein Gel ist oder umfasst. Die Ansteuerung einer derartigen magnetorheologischen Flüssigkeit erfolgt vergleichbar einem magnetorheologischen Elastomer.

Außerdem kann vorgesehen sein, dass das Material des Aktuatorelements eine elektrorheologische Flüssigkeit oder ein Gel ist oder umfasst. Hier kann durch Anlegen einer Spannung eine Ausdehnung der Flüssigkeit oder des Gels erreicht werden.

Darüber hinaus kann vorgesehen sein, dass das Material des Aktuatorelementes ein dielektrisches Elastomer ist oder umfasst.

Dielektrischen Elastomeraktuatoren (DEA) bestehen insbesondere aus einer weichen Elastomerfolie mit einem elektrisch stark isolierenden Grundmaterial (meist Silikon-, Polyuretan- oder Acrylelastomere sowie auch Naturkautschuk) und beispielsweise zwei hochflexiblen, dehnfähigen und gleichzeitig hochleitenden Elektroden. Beim Anlegen einer elektrischen Spannung zwischen den Elektroden zieht sich die Elastomerfolie in der Dicke zusammen und dehnt sich in der Fläche aus. Beim Abschalten der Spannung relativiert sich das Elastomer wieder in seine ursprüngliche Form. Durch Stapelung der dielektrischen Elastomerschichten können die Kraft und der Stellweg entsprechend vergrößert werden.

Des Weiteren kann vorgesehen sein, dass das Material des Aktuatorelements eine thermische Formgedächtnislegierung ist oder umfasst. Thermische Formgedächtnislegierungen (FGL) sind metallische Verbindungen, die sich bei einer Temperaturerhöhung verformen, indem das Material von einer martensitischen in eine austenitische Kristallstruktur übergeht. Die meist eingesetzten FGL sind Nickel-Titan-Legierungen. Das Material wird dabei insbesondere vor seiner Anwendung konditioniert. Bei einer Konditionierung für den Zwei-Wege-Effekt verformt sich das Material beim Abkühlen wieder in seine Ausgangsform zurück. Zu beachten ist dabei jedoch, dass eine Hysterese auftritt. Aufgrund der Verformung und des Übergangs von der martensitischen in eine austenitische Kristallstruktur sowie umgekehrt lassen sich jedoch gute und hohe Stellkräfte erzeugen.

Eine Ansteuerung kann beispielsweise durch eine entsprechende Wärmequelle gewährleistet werden.

Des Weiteren ist denkbar, dass das Material des Aktuatorelements eine magnetische Formgedächtnislegierung ist oder umfasst. Magnetische Formgedächtnislegierungen (MSMA = Magnetic Shape Memory Alloy) sind ebenfalls Metalle. Die gegenwärtig bevorzugte Form ist eine Nickel-Mangan-Gallium-Legierung. Auch hier kann die Verformung durch eine Kristallumwandlung des MSMA erfolgen, die jedoch im Gegensatz zur thermischen Formgedächtnislegierung durch Anlegen eines Magnetfeldes ausgelöst wird.

Darüber hinaus kann vorgesehen sein, dass mehrere in Reihe geschaltete Aktuatorelemente vorgesehen sind. Insbesondere können dabei die Aktuatorelemente zumindest teilweise eine Faltenbalgstruktur ausbilden.

Grundsätzlich ist denkbar, dass mehrere gleichartige Aktuatorelemente, d.h. mit gleichartiger bzw. identischer Materialauswahl verwendet werden. Grundsätzlich ist es alternativ oder zusätzlich auch möglich, mehrere Materialarten für die Aktuatorelemente, wie insbesondere wie vorstehend im Einzelnen beschrieben, zu kombinieren, insbesondere im Hinblick auf die Erreichung und Einstellung entsprechender Stellkräfte, aber auch Hubwege.

Der Hubweg des Aktuators kann insbesondere im Bereich einiger Millimeter liegen, wobei sich insbesondere ein Hubweg von größer einem Millimeter, insbesondere im Bereich zwischen 5 bis 10 Millimeter als vorteilhaft herausgestellt hat. Grundsätzlich denkbar sind aber auch Hubwege größer 10 Millimeter, insbesondere dann, wenn es sich um die Steuerung von Fluidwegen für Flüssigkeiten handelt.

Des Weiteren kann vorgesehen sein, dass das Material des Aktuatorelementes eine Piezokeramik ist oder umfasst. Mittels eines Piezoaktuators kann eine einfache und zuverlässige Ansteuerung gewährleistet werden. Darüber hinaus können vergleichsweise einfach die notwendigen Stellkräfte erreicht werden.

Insbesondere ist auch denkbar, dass das Aktuatorelement wenigstens einen Piezokeramikstapel aufweist. Hierüber lässt sich der Hubweg des Aktuators einfach einstellen.

Außerdem kann vorgesehen sein, dass das Aktuatorelement ein Piezo-Drucksensor ist. Hierbei kann insbesondere ausgenutzt werden, dass die Piezokeramik auch im Hinblick auf die anliegenden Drücke und Kräfte nicht nur als Aktuator, sondern gleichzeitig auch als Sensor genutzt werden kann. Dadurch wird eine Funktionsintegrierung möglich.

Auch hier ist grundsätzlich möglich, dass ein Aktuator, der eine Piezokeramik umfasst, mit anders gearteten Aktuatorelementen, insbesondere Aktuatorelementen bestehend oder umfassend weitere Materialien wie vorstehend dargestellt, kombiniert werden kann.

Das Aktuatorelement kann in einer ersten Ausdehnung eine Schaltstellung definieren, in der eine Fluidventilmembran in den wenigstens einen Fluidweg der Befüllungseinheit dichtend betätigt ist und das Aktuatorelement kann in der zweiten Ausdehnung eine Schaltstellung definieren, in der die Fluidventilmembran nicht dichtend betätigt ist.

Durch die Kombination von Aktuator und Fluidventilmembran und die entsprechende funktionale Verknüpfung kann eine einfache Steuerung des Fluidweges der Befüllungseinheit erreicht werden.

Darüber hinaus betrifft die vorliegende Erfindung eine Getränkeabfüllanlage mit wenigstens einem Aktuator oder mit wenigstens einer Befüllungseinheit wie vorstehend dargestellt.

Weitere Einzelheiten und Vorteile der Erfindung sollen nun anhand eines in den Zeichnungen dargestellten Ausführungsbeispiels näher erläutert werden.

Es zeigen:
- Fig. 1: eine schematische Schnittdarstellung einer erfindungsgemäßen Getränkeabfüllanlage mit einer erfindungsgemäßen Befüllungseinheit sowie einen erfindungsgemäßen Aktuator;
- Fig. 2a-d: schematische Darstellungen eines ersten Ausführungsbeispiels eines Aktuators ausgeführt als dielektrischer Elastomer-Aktuator;
- Fig. 3a-b: schematische Darstellungen eines ersten Ausführungsbeispiels eines Aktuators ausgeführt als magnetorheologischer Elastomer-Aktuator;
- Fig. 4a-b: schematische Darstellungen eines ersten Ausführungsbeispiels eines Aktuators umfassend thermische Formgedächtnislegierungen (magnetische Formgedächtnislegierungen);
- Fig. 5a-b: schematische Darstellungen eines ersten Ausführungsbeispiels eines Aktuators umfassend magnetorheologische Flüssigkeiten; und
- Fig. 6a-b: schematische Darstellungen eines ersten Ausführungsbeispiels eines Aktuators umfassend eine Piezokeramik.

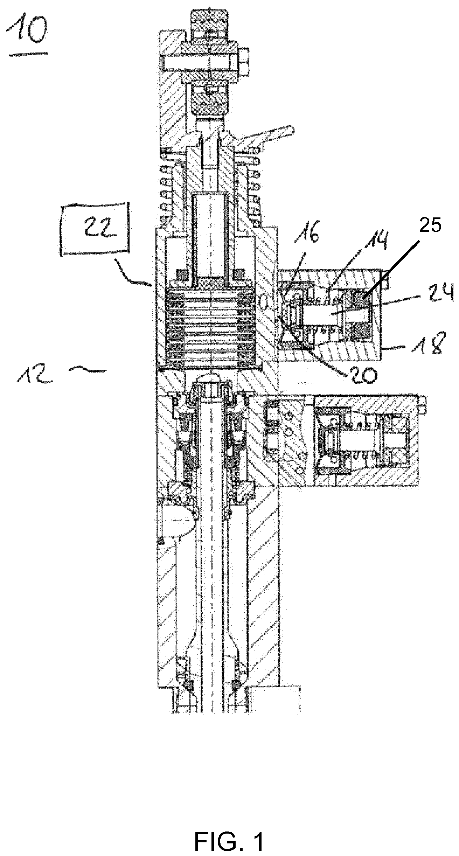

Fig. 1 zeigt eine schematische Schnittdarstellung in der Seitenansicht einer erfindungsgemäßen Getränkeabfüllanlage 10, hier teilweise dargestellt durch eine Befüllungseinheit 12 mit einem Aktuator 14 zur Steuerung wenigstens eines Fluidweges 20.

Der Aktuator 14 ist gemeinsam mit einer Fluidventilmembran 16 in einem Gehäuseteil 18 der Befüllungseinheit 12 angeordnet.

Des Weiteren ist eine Steuereinheit 22 vorgesehen.

Mittels der Steuereinheit 22 kann wenigstens ein erstes Steuersignal und wenigstens ein zweites Steuersignal bereitgestellt werden.

Der Aktuator 14 weist ferner ein Aktuatorelement 24 auf.

Das Aktuatorelement 24 besteht zumindest teilweise aus einem Material, das in Abhängigkeit von einem ersten Steuersignal der Steuereinheit 22 eine erste Ausdehnung annimmt, in der das Aktuatorelement 24 eine erste Ruheposition einnimmt, und dass in Abhängigkeit von einem zweiten Steuersignal eine Ausdehnung annimmt, in der das Aktuatorelement 24 eine zweite Anstellposition einnimmt. Das am freien Ende des Aktuator befindliche ringartige Element ist vorliegend ein Dämpfungselement 25, der bedarfsweise vorgesehen werden kann. Mit dem Aktuator 14 können Schaltseiten im Bereich von ca. 40ms in beide Richtungen ausgeführt werden.

Denkbar ist dabei auch, dass ein Hubweg der Fluidventilmembran 16 in einem Bereich von ca. 6mm oder auch mehr, insbesondere beispielsweise im Zusammenhang mit Flüssigkeiten von mehr als 10mm möglich sind.

Die Stellkraft beträgt 200-400 N, insbesondere ca. 350-370 N, vorzugsweise ca. 360 N liegen.

Der Fluidweg 20 kann beispielsweise eine Abmessung von ca. 24mm aufweisen. Arbeitsdrücke können im Bereich zwischen 3 bis 10 bar, insbesondere 8 bar oder bei Anpassung der Membranfläche der Fluidventilmembran 16 bei ca. 6 bar liegen. Bei den Schaltzeiten kann als weitere Charakteristik erreicht werden, dass 3 Schaltzyklen in einem Zeitraum von höchstens 1,2s durchgeführt werden können.

Die Funktion des Aktuators 14 besteht darin, die Fluidventilmembran 16 in wenigstens einer ersten Schaltstellung freizugeben und in wenigstens einer zweiten Schaltstellung derart zu betätigen, dass sie einen Fluidweg 20 der Befüllungseinheit 12 dichtend verschließt.

Das Aktuatorelement 24 betätigt in der ersten Ausdehnung eine erste Schaltstellung, in der die Fluidventilmembran 16 in dem Fluidweg 20 der Befüllungseinheit 12 dichtend betätigt ist (geschlossene Stellung) und in der zweiten Ausdehnung eine zweite Schaltstellung, in der die Fluidventilmembran 16 nicht betätigt ist (offene Stellung).

Grundsätzlich kann vorgesehen sein, dass der Aktuator 14 eine NORMAL OFFEN Ausführung betrifft, in der der Aktuator 14 im nicht betätigten Zustand die Fluidventilmembran 16 nicht betätigt.

Grundsätzlich kann aber auch vorgesehen sein, dass der Aktuator 14 eine NORMAL GESCHLOSSEN Konfiguration aufweist, dies bedeutet, dass der Aktuator 14 im nicht betätigten Zustand dafür sorgt, dass die Fluidventilmembran 16 dichtend betätigt ist und den Fluidweg 20 der Befüllungseinheit 12 dichtend verschließt.

Bei einer zur Figur 1 analogen, alternativen Ausführungsform, die nicht gesondert dargestellt ist, ist das Aktuatorelement 24 formstabil, d.h. nicht zur Formänderung anregbar. In diesem Fall ist am freien Ende des Aktuatorelementes 24, dort wo in der Figur 1 das Dämpfungselement 25 angeordnet ist, statt dessen ein Endaktuator mit den vorstehend beschriebenen Materialeigenschaften angeordnet.

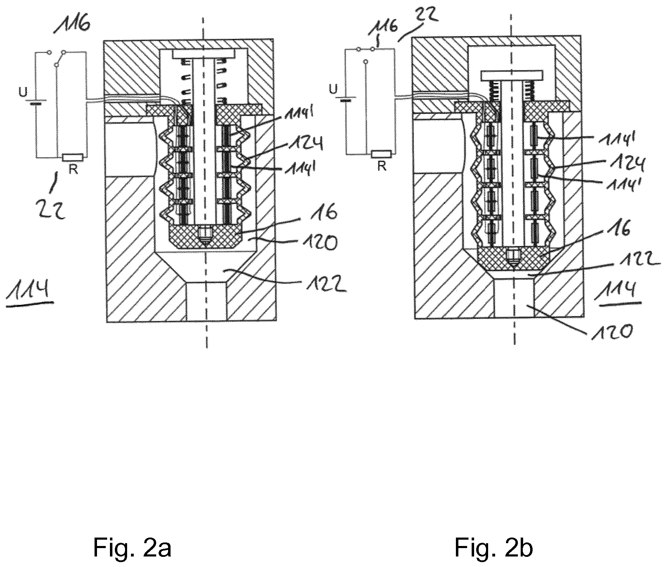

In den Fig. 2a - d ist schematisch eine erste Ausführungsform eines dielektrischen Elastomer-Aktuators 114 dargestellt, der in der Befüllungseinheit 12 gemäß Fig. 1 eingebaut sein kann.

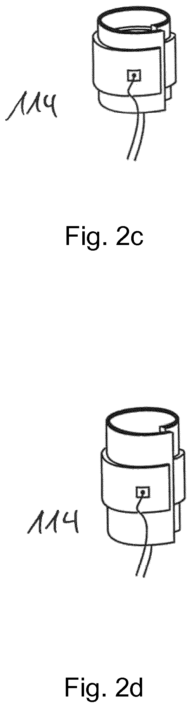

Der Aktuator 114 ist als dielektrischer Elastomer-Aktuator ausgebildet, und zwar in einer aufgerollten Konfiguration, wie in den Fig. 2c und 2d dargestellt.

Fig. 2c zeigt den Aktuator 114 im Ausgangszustand, in der der Aktuator 114 stromlos und kurzgeschlossen ist und Fig. 2d den ausgedehnten Zustand, in dem der Aktuator 114 mit Strom beaufschlagt ist.

Der Aktuator 114 kann dabei sowohl in einer NORMAL GESCHLOSSEN als auch einer NORMAL OFFEN Konfiguration realisiert werden, die in den Fig. 2a und 2b gezeigte Konfiguration ist eine NORMAL OFFEN Konfiguration.

Der Aktuator 114 wird durch das Anlegen einer Spannung U über eine über die Steuereinheit 22 aktivierte Stromquelle 116 aktiviert. Der Fluidweg 120 weist eine kegelzylindrische Aufweitung 122 auf, in die die Fluidventilmembran 16 im geschlossenen Zustand, wie in Fig. 2b gezeigt, dichtend schließend durch den Aktuator 114 angestellt wird.

Der Aktuator 114 weist mehrere hintereinander geschaltete Aktuatoren 114' auf, die in einem Faltenbalggebilde 124 (bestehend zum Beispiel aus mehreren miteinander verbundenen Faltenbalgsegmenten), die dazu dienen, den Gesamthub des Aktuators 114 zu vergrößern.

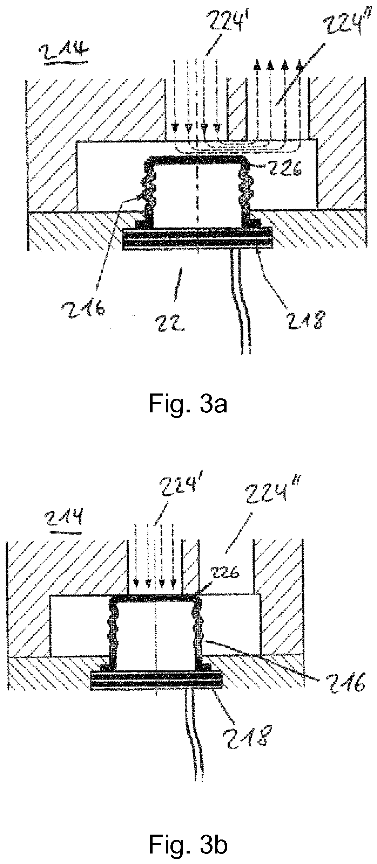

In den Fig. 3a und 3b ist ein weiterer Aktuator 214 gezeigt, der als Aktuator 214 ein magnetorheologisches Elastomer 216 aufweist.

Der Aktuator 214 kann dabei sowohl in einer NORMAL GESCHLOSSEN als auch einer NORMAL OFFEN Konfiguration realisiert werden, die in den Fig. 3a und 3b gezeigte Konfiguration ist eine NORMAL OFFEN Konfiguration.

Das magnetorheologische Elastomer 216 ist als weiche Elastomermatrix ausgeführt, in der magnetische Partikel eingebracht sind.

Das magnetorheologische Elastomer 216 wird mittels eines Elektromagnets 218 aktiviert, insbesondere über entsprechende Steuersignale der Steuereinheit 22.

Fig. 3a zeigt, dass die hier nicht polarisierten und nicht ausgerichteten (oder chaotisch verteilten) Partikel in dem magnetorheologischen Elastomer 216, das umlaufend um den faltenbalgartig geformten, becherartigen Aktuator 214 angeordnet ist, hier dazu führt, dass der Aktuator 214 eine erste Ausdehnung hat, in der er im Wesentlichen zusammengefaltet ist.

Bei ausgeschaltetem Elektromagnet, wie in Fig. 3a dargestellt, erfolgt die Rückstellung des elastischen Schaltkörpers über eine eigene, durch eine formgegebene Rückstellkraft (hier Faltenbalgstruktur) oder durch anliegenden Druck oder Strömung aus dem Fluidkanal 224' bzw. 224".

Grundsätzlich ist auch möglich, dass eine innen- oder außenliegende, angreifende Rückholfeder vorgesehen ist (vgl. insbesondere hierzu Fig. 1, in der eine solche Rückholfeder gezeigt ist).

Die Fluidwege 224' und 224" sind eine mögliche Ausführungsform des in Fig. 1 gezeigten Fluidwegs 20.

Wie in Fig. 3b gezeigt, wird durch Bestromen des Elektromagnets 218 die Partikel des magnetorheologischen Elastomers 216 polarisiert und ausgerichtet und hierdurch die an dem magnetorheologischen Elastomer 216 angeordnete Fluidventilmembran 226, die eine mögliche Ausführungsform der Fluidventilmembran 16 ist, gegen die Ausflussöffnung des Fluidweges 224' dichtend schließend gepresst.

Durch die Ausrichtung des magnetorheologischen Elastomers 216 erfolgt das Erzeugen einer Stellkraft, das zum Verschließen des Zulaufkanals 224' gegen den anliegenden Druck, ggf. gegen eine eigene Rückstellkraft oder eine Rückholfeder ausreichend ist.

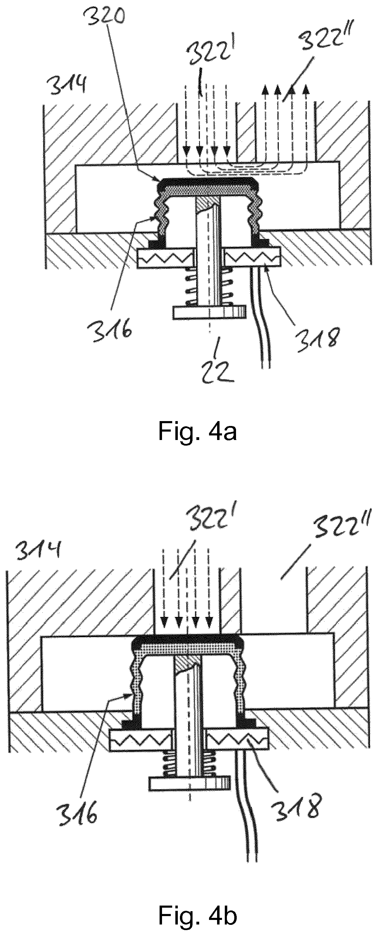

In den Fig. 4a und 4b ist eine weitere Ausführungsform eines Aktuators 314 vorgesehen, der in der Befüllungseinheit 12 gemäß Fig. 1 Anwendung finden kann.

Der Aktuator 314 weist eine thermische Formgedächtnislegierung 316 (magnetische Formgedächtnislegierung) auf.

Dabei ist der Aktuator 314 in einer NORMAL OFFEN Konfiguration ausgebildet und wie in Fig. 1 gezeigt, ist die Formgedächtnislegierung 316 im kalten Zustand bei ausgeschalteter Heizung 318 gezeigt.

Der Aktuator 314 kann grundsätzlich sowohl in einer NORMAL GESCHLOSSEN als auch einer NORMAL OFFEN Konfiguration realisiert werden.

Die Ansteuerung der Heizung 318 erfolgt wiederum über die Steuereinheit 22.

Die Rückstellung des Aktuators 314 kann durch eine innen oder außen angreifende Rückholfeder erfolgen (erforderlich bei einem Werkstoff mit einem Einweg-Memory-Effekt).

In einem Fall, in dem die thermische Formgedächtnislegierung 316 als magnetische Formgedächtnislegierung ausgebildet ist, kann die Aktuierung durch einen entsprechenden Magneten erfolgen.

Die thermische Formgedächtnislegierung 316 ist in Fig. 4a in der Konfiguration eines magensitischen, verschobenen Metallgitters (plastisch verformt).

Auf der Formgedächtnislegierung 316 ist eine Fluidventilmembran 320 angeordnet, mittels derer der Fluidzulauf 322' verschließen lässt (siehe Fig. 4b).

Der Fluidweg 20 besteht hier, analog dem in Fig. 3a, b gezeigten Ausführungsbeispiel aus dem Zulauf 322' und dem Fluidablauf 322".

Wie in Fig. 4b gezeigt, wird durch Erwärmen der Formgedächtnislegierung 316 ein austenitisches, gerichtetes Metallgitter erzeugt, wodurch die Fluidventilmembran 320 gegen die Öffnung des Fluidzulaufs 322' gepresst wird und diesen damit dichtend verschließt.

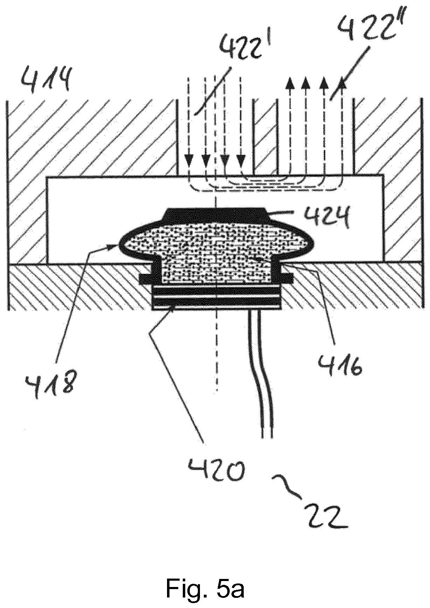

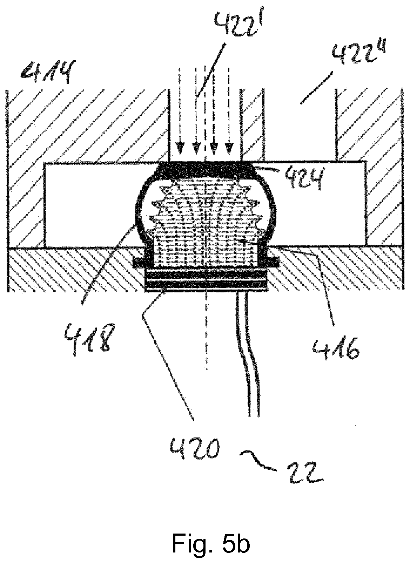

In Fig. 5a, b ist eine weitere Ausführungsform eines Aktuators 414 für die Befüllungseinheit 12 gemäß Fig. 1 gezeigt.

Der Aktuator 414 kann dabei sowohl in einer NORMAL GESCHLOSSEN als auch einer NORMAL OFFEN Konfiguration realisiert werden, die in den Fig. 5a und 5b gezeigte Konfiguration ist eine NORMAL OFFEN Konfiguration.

Der Aktuator 414 weist eine magnetorheologische Flüssigkeit 416 auf, die in einer elastischen Hülle 418 aufgenommen ist.

Über einen Elektromagneten 420, der über die Steuereinheit 22 angesteuert werden kann, kann der Aktuator 414 betätigt werden. Auch hier ist der Fluidweg 20 der Befüllungseinheit 12, wie in Fig. 1 gezeigt, als Fluidzulauf 422' und als Fluidablauf 422" ausgebildet.

Wie in Fig. 5b gezeigt, wird durch Bestromen des Elektromagneten 420 die magnetorheologische Flüssigkeit 416 zur Ausdehnung gebracht und die auf der elastischen Hülle 418 angeordnete Fluidventilmembran 424 gegen die Öffnung des Fluidzulaufs 422' dichtend schließend angestellt.

In Fig. 5a sind die magnetischen Teilchen in der magnetorheologischen Flüssigkeit 416 chaotisch angeordnet und bei eingeschaltetem Elektromagneten 420, wie in Fig. 5b gezeigt, werden die magnetischen Teilchen in der magnetorheologischen Flüssigkeit 416 gerichtet angeordnet, was zu der entsprechenden Ausdehnung und Anstellung des Aktuators 414 gegen die Öffnung des Fluidzulaufs 422' führt.

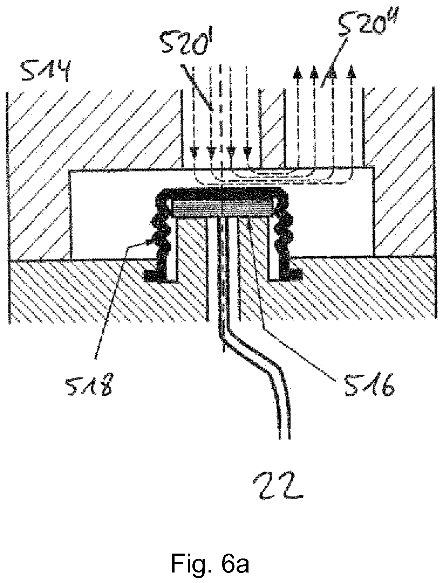

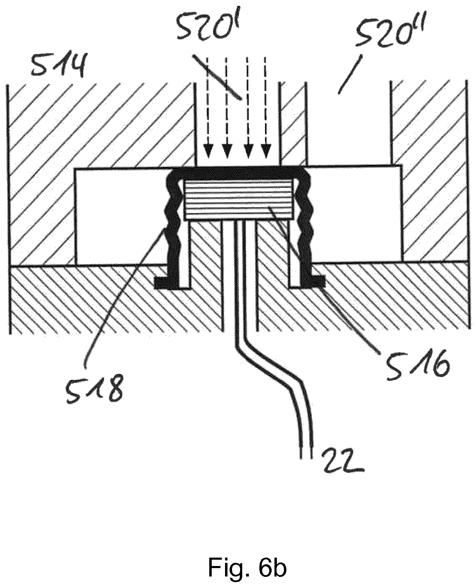

In den Fig. 6a und 6b ist eine weitere Ausführungsform eines Aktuators 514 gezeigt, der über einen Stapel Piezokeramiken 516 und ein weiches Dichtungselastomer 518 verfügt, das die Funktion der Fluidventilmembran übernimmt.

Über eine nicht näher gezeigte Stromquelle, die über die Steuereinheit 22 angesteuert werden kann, können die Piezokeramiken 516 bestromt werden.

Auch hier ist der Fluidweg in einen Fluidzulauf 520' und einen Fluidablauf 520" ausgebildet.

Der Aktuator 514 kann dabei sowohl in einer NORMAL GESCHLOSSEN als auch einer NORMAL OFFEN Konfiguration realisiert werden, die in den Fig. 6a und 6b gezeigte Konfiguration ist eine NORMAL OFFEN Konfiguration.

Im unbestromten Zustand, wie in Fig. 6a gezeigt, sind die Piezokeramiken 516 nicht ausgedehnt, so dass das Dichtungselastomer 518 nicht gegen die Öffnung des Fluidzulaufs 520' angestellt ist.

In Fig. 6b ist der Zustand gezeigt, in dem die Piezokeramiken bestromt sind, so dass das weiche Dichtungselastomer 518 mit der Funktion einer Fluidventilmembran dichtend schließend gegen die Öffnung des Fluidzulaufs 520' angestellt ist.

Die Schaltung erfolgt beispielsweise über einen inversen piezo-elektrischen Effekt.

Nach dem Verschließen der Bohrung des Fluidzulaufs 520' mit einem festen Wert kann eine Änderung der dem Piezoelement entgegengebrachten Kraft zur Druckmessung der angeschlossenen Kammer dienen.

Somit kann das Piezoelement 516 sowohl als Aktuator als auch als Sensor dienen.

### Bezugszeichenliste

- 10: Getränkeabfüllanlage
- 12: Befüllungseinheit
- 14: Aktuator
- 16: Fluidventilmembran
- 18: Gehäuseteil
- 20: Fluidweg
- 22: Steuereinheit
- 24: Aktuatorelement
- 25: ...

- 114: dielektrischer Elastomer-Aktuator
- 116: Stromquelle
- 120: Fluidweg
- 122: kegelzylindrische Aufweitung
- 124: Faltenbalggebilde
- 114': Aktuator
- U: Spannung

- 214: Aktuator
- 216: magnetorheologisches Elastomer
- 218: Elektromagnet
- 226: Fluidventilmembran
- 224': Fluidweg
- 224": Fluidweg

- 314: Aktuator
- 316: Formgedächtnislegierung
- 318: Heizung
- 320: Fluidventilmembran
- 322': Fluidzulauf
- 322": Fluidablauf

- 414: Aktuator
- 416: magnetorheologische Flüssigkeit
- 418: elastische Hülle
- 420: Elektromagnet
- 424: Fluidventilmembran
- 422': Fluidzulauf
- 422": Fluidablauf

- 514: Aktuator
- 516: Piezokeramik
- 518: Dichtungselastomer
- 520': Fluidzulauf
- 520": Fluidablauf

## Patentansprüche

1. Befüllungseinheit für eine Getränkeabfüllanlage (10) mit wenigstens einem Aktuator (14) zur Steuerung wenigstens eines Fluidweges (20) der Befüllungseinheit (12) mit wenigstens einer Steuereinheit (22) und mit wenigstens einem Aktuatorelement (24), mittels dessen eine Stellkraft bereitstellbar ist, wobei mittels der Steuereinheit (22) wenigstens ein erstes Steuersignal und wenigstens ein zweites Steuersignal bereitstellbar ist , **dadurch gekennzeichnet, dass** das Aktuatorelement (24) aus einem Material besteht, das in Abhängigkeit von einem ersten Steuersignal eine erste Ausdehnung annimmt, in der das Aktuatorelement (24) eine erste Ruheposition einnimmt, und das in Abhängigkeit von dem zweiten Steuersignal eine Ausdehnung annimmt, in der das Aktuatorelement (24) eine zweite Anstellposition einnimmt, wobei die Stellkraft 200-400 N, insbesondere 350-370 N, vorzugsweise 360 N beträgt.

2. Befüllungseinheit (12) nach Anspruch 1, **dadurch gekennzeichnet, dass** das Material des Aktuatorelementes (24) ein magnetorheologisches Elastomer (216) ist oder umfasst.

3. Befüllungseinheit (12) nach Anspruch 1, **dadurch gekennzeichnet, dass** das Material des Aktuatorelementes (24) eine magnetorheologische Flüssigkeit (416) oder ein Gel ist oder umfasst.

4. Befüllungseinheit (12) nach Anspruch 1, **dadurch gekennzeichnet, dass** das Material des Aktuatorelementes (24) eine elektrorheologische Flüssigkeit oder ein Gel ist oder umfasst.

5. Befüllungseinheit (12) nach Anspruch 1, **dadurch gekennzeichnet, dass** das Material des Aktuatorelementes (24) ein dielektrisches Elastomer (114) ist oder umfasst.

6. Befüllungseinheit (12) nach Anspruch 1, **dadurch gekennzeichnet, dass** das Material des Aktuatorelementes (24) eine thermische Formgedächtnislegierung (316) ist oder umfasst.

7. Befüllungseinheit (12) nach Anspruch 1, **dadurch gekennzeichnet, dass** das Material des Aktuatorelementes (24) eine magnetische Formgedächtnislegierung ist oder umfasst.

8. Befüllungseinheit (12) nach einem der Ansprüche 1 bis 7, **dadurch gekennzeichnet, dass** mehrere in Reihe geschaltete Aktuatorelemente (24) vorgesehen sind, insbesondere wobei die Aktuatorelemente (24) zumindest teilweise eine Faltenbalgstruktur (124) ausbilden.

9. Befüllungseinheit (12) nach Anspruch 1, **dadurch gekennzeichnet, dass** das Material des Aktuatorelementes (24) eine Piezokeramik (516) ist oder umfasst.

10. Befüllungseinheit (12) nach Anspruch 9, **dadurch gekennzeichnet, dass** das Aktuatorelement (24) wenigstens einen Piezokeramikstapel aufweist.

11. Befüllungseinheit (12) nach Anspruch 9 oder Anspruch 10, **dadurch gekennzeichnet, dass** das Aktuatorelement (24) ein Piezo-Drucksensor ist.

12. Befüllungseinheit (12) nach einem der vorhergehenden Ansprüche, **dadurch gekennzeichnet, dass** das Aktuatorelement (24) in der ersten Ausdehnung eine Schaltstellung definiert, in der eine Fluidventilmembran (16) in dem wenigstens einen Fluidweg (20) der Befüllungseinheit (12) dichtend betätigt ist und dass das Aktuatorelement (24) in der zweiten Ausdehnung eine Schaltstellung definiert, in der eine Fluidventilmembran (16) nicht dichtend betätigt ist.

13. Getränkeabfüllanlage (10) mit wenigstens einer Befüllungseinheit (12) nach einem der Ansprüche 1 bis Anspruch 12.

## Claims

1. Filling unit for a beverage filling system (10) with at least one actuator (14) for controlling at least one fluid path (20) of the filling unit (12), with at least one control unit (22) and with at least one actuator element (24), by means of which an actuating force can be provided, wherein, by means of the control unit (22) at least one first control signal and at least one second control signal can be provided, **characterised in that** the actuator element (24) consists of a material which, as a function of a first control signal, assumes a first extension position, in which the actuator element (24) assumes a first resting position, and which, as a function of the second control signal, assumes an extension position in which the actuator element (24) assumes a second activation position, wherein the actuating force amounts to 200-400 N, in particular 350-370 N, and preferably 360 N.

2. Filling unit (12) according to claim 1, **characterised in that** the material of the actuator element (24) is or comprises a magnetorheological elastomer (216).

3. Filling unit (12) according to claim 1, **characterised in that** the material of the actuator element (24) is or comprises a magnetorheological fluid (416) or a gel.

4. Filling unit (12) according to claim 1, **characterised in that** the material of the actuator element (24) is or comprises an electrorheological fluid or a gel.

5. Filling unit (12) according to claim 1, **characterised in that** the material of the actuator element (24) is or comprises an electrical elastomer (114).

6. Filling unit (12) according to claim 1, **characterised in that** the material of the actuator element (24) is or comprises a thermal shape-memory alloy (316).

7. Filling unit (12) according to claim 1, **characterised in that** the material of the actuator element (24) is or comprises a magnetic shape-memory alloy.

8. Filling unit (12) according to any one of claims 1 to 7, **characterised in that** a plurality of actuator elements (24) connected in a row are provided, in particular wherein the actuator elements (24) form at least partially a folding bellows structure (124).

9. Filling unit (12) according to claim 1, **characterised in that** the material of the actuator element (24) is or comprises a piezo ceramic (516).

10. Filling unit (12) according to claim 9, **characterised in that** the material of the actuator element (24) comprises at least one piezo ceramic stack.

11. Filling unit (12) according to claim 9 or claim 10, **characterised in that** the actuator element (24) is a piezo pressure sensor.

12. Filling unit (12) according to any one of the preceding claims, **characterised in that** the actuator element (24) in a first extension defines a switching position in which a fluid membrane (16) is actuated with a sealing effect in the at least one fluid path (20) of the filling unit (12), and that the actuator element (24) in the second extension defines a switching position in which a fluid valve membrane (16) is actuated without a sealing effect.

13. Beverage filling system (10) with at least one filling unit (12) according to any one of claims 1 to 12.

## Revendications

1. Unité de remplissage pour une installation de conditionnement de boisson (10) avec au moins un actionneur (14) pour commander au moins une trajectoire de fluide (20) de l'unité de remplissage (12) avec au moins une unité de commande (22) et avec au moins un élément actionneur (24), au moyen duquel une force de réglage peut être fournie, dans laquelle au moins un premier signal de commande et au moins un deuxième signal de commande peuvent être fournis au moyen de l'unité de commande (22),
**caractérisée en ce que**
l'élément actionneur (24) est constitué d'un matériau qui prend la forme, en fonction d'un premier signal de commande, d'une première expansion, dans laquelle l'élément actionneur (24) adopte une première position de repos, et qui prend la forme, en fonction du deuxième signal de commande, d'une expansion, dans laquelle l'élément actionneur (24) adopte une deuxième position de contact, dans laquelle la force de réglage est de 200-400 N, en particulier de 350 - 370 N, de préférence de 360 N.

2. Unité de remplissage (12) selon la revendication 1, **caractérisée en ce que** le matériau de l'élément actionneur (24) est ou comprend un élastomère magnétorhéologique (216).

3. Unité de remplissage (12) selon la revendication 1, **caractérisée en ce que** le matériau de l'élément actionneur (24) est ou comprend un liquide magnétorhéologique (416) ou un gel.

4. Unité de remplissage (12) selon la revendication 1, **caractérisée en ce que** le matériau de l'élément actionneur (24) est ou comprend un liquide électrorhéologique ou un gel.

5. Unité de remplissage (12) selon la revendication 1, **caractérisée en ce que** le matériau de l'élément actionneur (24) est ou comprend un élastomère diélectrique (114).

6. Unité de remplissage (12) selon la revendication 1, **caractérisée en ce que** le matériau de l'élément actionneur (24) est ou comprend un alliage thermique à mémoire de forme (316).

7. Unité de remplissage (12) selon la revendication 1, **caractérisée en ce que** le matériau de l'élément actionneur (24) est ou comprend un alliage magnétique à mémoire de forme.

8. Unité de remplissage (12) selon l'une quelconque des revendications 1 à 7, **caractérisée en ce que** plusieurs éléments actionneurs (24) branchés en série sont prévus, en particulier dans laquelle les éléments actionneurs (24) forment au moins en partie une structure à soufflets (124).

9. Unité de remplissage (12) selon la revendication 1, **caractérisée en ce que** le matériau de l'élément actionneur (24) est ou comprend une céramique piézoélectrique (516).

10. Unité de remplissage (12) selon la revendication 9, **caractérisée en ce que** l'élément actionneur (24) présente au moins un empilement de céramique piézoélectrique.

11. Unité de remplissage (12) selon la revendication 9 ou la revendication 10, **caractérisée en ce que** l'élément actionneur (24) est un capteur de pression piézoélectrique.

12. Unité de remplissage (12) selon l'une quelconque des revendications précédentes, **caractérisée en ce que** l'élément actionneur (24) définit dans la première expansion une position de commutation, dans laquelle une membrane de soupape de régulation de fluide (16) est actionnée de manière à assurer l'étanchéité sur l'au moins une trajectoire de fluide (20) de l'unité de remplissage (12), et que l'élément actionneur (24) définit dans la deuxième expansion une position de commutation, dans laquelle une membrane de soupape de régulation de fluide (16) n'est pas actionnée de manière à assurer l'étanchéité.

13. Installation de conditionnement de boisson (10) avec au moins une unité de remplissage (12) selon l'une quelconque des revendications 1 à 12.
